# EUROPÄISCHE PATENTSCHRIFT

(11) **EP 3 036 780 B1**
(45) Veröffentlichungstag und Bekanntmachung des Hinweises auf die Patenterteilung: **16.10.2019**
(21) Anmeldenummer: 14761297.2
(22) Anmeldetag: 25.08.2014
(51) Int. Cl.: H01L 51/44, H01L 51/48

(54) **LANGZEITSTABILE, AUS LÖSUNGEN ABSCHEIDBARE PHOTOVOLTAISCHE ELEMENTE UND IN-SITU-VERFAHREN ZU DEREN HERSTELLUNG**
PHOTOVOLTAIC ELEMENTS HAVING LONG-TERM STABILITY THAT CAN BE PRECIPITATED OUT OF SOLUTIONS, AND IN-SITU METHOD FOR PRODUCING SAID ELEMENTS
ÉLÉMENTS PHOTOVOLTAÏQUES DURABLES POUVANT ÊTRE DÉPOSÉS À PARTIR DE SOLUTIONS ET PROCÉDÉ IN-SITU POUR LEUR FABRICATION

(30) Priorität: 23.08.2013 DE 102013216848
(43) Veröffentlichungstag der Anmeldung: 29.06.2016
(73) Patentinhaber: Fraunhofer-Gesellschaft zur Förderung der angewandten Forschung e.V., 80686 München (DE)
(72) Erfinder: HINSCH, Andreas, 79254 Oberried (DE); BRANDT, Henning, 27777 Ganderkesee (DE)
(74) Vertreter: Pfenning, Meinig & Partner mbB
(86) Internationale Anmeldenummer: PCT/EP2014/067983
(87) Internationale Veröffentlichungsnummer: WO 2015/025058

(56) Entgegenhaltungen:
- JP-A- 2010 009 786
- US-A1- 2009 133 741
- TIAN ZHIPENG ET AL: "Multilayer structure with gradual increasing porosity for dye-sensitized solar cells", APPLIED PHYSICS LETTERS, AMERICAN INSTITUTE OF PHYSICS, US, Bd. 94, Nr. 3, 23. Januar 2009 (2009-01-23), Seiten 31905-31905, XP012118662, ISSN: 0003-6951, DOI: 10.1063/1.3073834
- SASTRAWAN R ET AL: "New interdigital design for large area dye solar modules using a lead-free glass frit sealing", PROGRESS IN PHOTOVOLTAICS: RESEARCH AND APPLICATIONS, JOHN WILEY & SONS, LTD, Bd. 14, Nr. 8, 19. Juni 2006 (2006-06-19), Seiten 697-709, XP008144509, ISSN: 1062-7995, DOI: 10.1002/PIP.700 [gefunden am 2006-06-19]
- KENGO SADAMASU ET AL: "Hybrid Dye-Sensitized Solar Cells Consisting of Double Titania Layers for Harvesting Light with Wide Range of Wavelengths", APPLIED PHYSICS EXPRESS, JAPAN SOCIETY OF APPLIED PHYSICS; JP, JP, Bd. 4, Nr. 2, 21. Dezember 2011 (2011-12-21), Seiten 22301-1, XP001564470, ISSN: 1882-0778, DOI: 10.1143/APEX.4.022301 [gefunden am 2011-01-21]

## Beschreibung

Die vorliegende Erfindung betrifft ein photovoltaisches Element, das neben einer Frontelektrode und einer weiteren Elektrode mindestens zwei poröse Trägerschichten, mehrere Glaslotstege und mindestens ein photovoltaisches Material enthält. Die beiden Elektroden enthalten dabei jeweils ein Glassubstrat und jeweils eine auf dem Glassubstrat angeordnete elektrisch leitfähige Elektrodenschicht. Die mindestens zwei porösen Trägerschichten sind zwischen den beiden Elektroden angeordnet, wobei die beiden Elektroden ohne räumlichen Abstand mit den angrenzenden porösen Trägerschichten verbunden sind. Die Glaslotstege sind zwischen den beiden Elektroden zur Fixierung der mindestens zwei porösen Trägerschichten angeordnet. Das mindestens eine photovoltaisch aktive Material ist in die mindestens zwei porösen Trägerschichten eingebracht und weist einen Konzentrationsgradienten auf. Außerdem betrifft die vorliegende Erfindung ein in-situ-Verfahren zur Herstellung eines erfindungsgemäßen photovoltaischen Elementes sowie ein Modul, das aus mindestens zwei der erfindungsgemäßen photovoltaischen Elemente besteht.

Das technische Gebiet der vorliegenden Erfindung betrifft die Herstellung von Solarzellen bzw. photovoltaischen Elementen und Modulen. Der Stand der Technik, insbesondere WO 96/29716 und WO 2005/096391 A3, beschreiben diesbezüglich eine spezielle Ausführung von nano-skalischen Solarzellen, sogenannten Farbstoffsolarzellen in einem Zwei-Elektrodenaufbau, die zwischen zwei Gläsern mittels Glaslot versiegelt werden kann. TIAN ZHIPENG ET AL: APPLIED PHYSICS LETTERS, Bd. 94, Nr. 3, 23. Januar 2009, Seiten 31905-31905, SASTRAWAN R ET AL: PROGRESS IN PHOTOVOLTAICS: RESEARCH AND APPLICATIONS, JOHN WILEY & SONS, LTD, Bd. 14, Nr. 8, 19. Juni 2006, Seiten 697-709, und US 2009/133741 A1 offenbaren Farbstoffsolarzellen mit porösen Trägerschichten.

Solche nano-skalischen Solarzellen können aus einer Vielfalt von photovoltaisch aktiven Materialien hergestellt werden. Für den Begriff der nano-skalischen Solarzellen werden in der wissenschaftlichen Literatur oft auch andere Begriffe gewählt. Teilweise wird z.B. von mesoskopischen Solarzellen gesprochen. EP 1442486 wählt dagegen den Begriff der "bulk-heterojunction" Solarzellen. Neueste Ansätze, wie beispielsweise in US 2012/0306053 A1, werden auch als "Perovskite" Solarzellen bezeichnet. Ein sehr interessanter Aspekt dieser Solarzellenkonzepte ist dabei, dass die photovoltaisch aktiven Materialien aus Lösungen abgeschieden werden können.

Die Herausforderung für die Kommerzialisierung von nano-skalischen Solarzellen liegt darin, sie mit Hilfe einfachster Produktionsverfahren, minimalem Materialaufwand und langzeitstabilen Eigenschaften herzustellen. Mit dem bisherigen Stand der Technik sind diese drei Anforderungen nicht vereinbar.

Ausgehend vom Stand der Technik ist es somit Aufgabe der vorliegenden Erfindung ein photovoltaisches Element anzugeben, dass auf der einen Seite hervorragende Eigenschaften in Bezug auf die Langzeitstabilität aufweist, andererseits aber auch mittels eines unkomplizierten Produktionsverfahrens und mit minimalem Materialaufwand herstellbar ist.

Diese Aufgabe wird durch ein photovoltaisches Element mit den Merkmalen des Patentanspruchs 1 gelöst. Patentanspruch 11 gibt außerdem ein Verfahren zur Herstellung eines solchen photovoltaischen Elementes an. Des Weiteren gibt Patentanspruch 16 ein photovoltaisches Modul an, das aus mindestens zwei der erfindungsgemäßen photovoltaischen Elemente besteht. Die abhängigen Patentansprüche stellen dabei vorteilhafte Weiterbildungen des photovoltaischen Elementes oder des Verfahrens dar.

Erfindungsgemäß wird somit ein photovoltaisches Element angegeben, das neben einer Frontelektrode und einer weiteren Elektrode mindestens zwei poröse Trägerschichten, mehrere Glaslotstege und mindestens ein photovoltaisches Material enthält. Die beiden Elektroden enthalten dabei jeweils ein Glassubstrat und eine elektrisch leitfähige Elektrodenschicht, welche auf dem Glassubstrat angeordnet ist, und zwar auf der Seite, die der jeweils anderen Elektrode zugewandt ist. Die mindestens zwei porösen Trägerschichten sind zwischen den beiden Elektroden angeordnet, wobei die beiden Elektroden ohne räumlichen Abstand mit den angrenzenden porösen Trägerschichten verbunden sind. Die Glaslotstege sind zwischen den beiden Elektroden zur Fixierung der mindestens zwei porösen Trägerschichten angeordnet. Das mindestens eine photovoltaisch aktive Material ist in die mindestens zwei porösen Trägerschichten eingebracht und weist einen Konzentrationsgradienten auf.

Die Erfindung zeichnet sich dadurch aus, dass die Glaslotstege so zwischen den beiden Elektroden angeordnet sind, dass die beiden Elektroden ohne räumlichen Abstand mit den angrenzenden porösen Trägerschichten verbunden sind, wodurch das photovoltaische Element eine hohe Langzeitstabilität aufweist. Dies kann erreicht werden, indem die beiden Elektroden durch die aufschmelzenden Glaslotstege in einem thermischen Fusingprozess langzeitstabil versiegelt werden, sodass im Gegensatz zum bisher bekannten Stand der Technik eben kein räumlicher Abstand zwischen den porösen Trägerschichten und den Elektroden entsteht. Dies ist möglich, da beim Fusen der Gläser oberhalb der Erweichungstemperatur der Glaslotstege sowie der Glassubstrate gearbeitet wird und sich die Gläser daher vollständig, d.h. ohne Abstand, aufeinander ablegen und so beim Abkühlen das erstarrende Glaslot die Elektroden dauerhaft fixiert.

Erfindungsgemäß wurde erkannt, dass bei der Verwendung sowie der erfindungsgemäßen Herstellung eines erfindungsgemäßen photovoltaischen Elementes viele Vorteile gegenüber den Ausführungen des bisherigen Stands der Technik erzielt werden können.

Zunächst kann durch die Versiegelung bei hohen Temperaturen mittels aufgeschmolzener Glaslotstege eine hohe Langzeitstabilität gewährleistet werden. Eine Versiegelung bei solch hohen Temperaturen wird dabei dadurch möglich, dass poröse nicht-organische Trägerschichten verwendet werden.

Weiterhin wird durch das nachträgliche Einbringen der photovoltaisch aktiven Materialien in die Zelle mittels Lösungen die innere Oberfläche der Trägerschichten durch Trocknung beschichtet. Damit entfällt im Gegensatz zu bestehenden Verfahren die Notwendigkeit eines zusätzlichen aufwändigen makroskopischen Beschichtungsprozesses für die photovoltaisch aktiven Materialien.

Außerdem ist ein einfaches inertes Handling der photovoltaisch aktiven Materialien in geschlossenen Schlauchsystemen möglich. Somit kann auf aufwendige Vakuum- oder Inertgastechniken verzichtet werden.

Ebenso sind die Anforderungen an Sicherheitsvorkehrungen im Umgang mit den Materialien, den Lösungsmitteln und der Trocknungsvorgänge stark verringert.

Ein weiterer Vorteil ist, dass durch die Minimierung des Abstandes der Glassubstrate eine Verringerung des Materialaufwandes des photovoltaisch aktiven Materials möglich wird.

Erfindungsgemäß kann als Material für die Glassubstrate Floatglas wie z.B. Kalknatronglas oder Borosilicatglas verwendet werden.

Als Material für die Glaslotstege kann erfindungsgemäß niedrigschmelzendes Glas z.B. auf Basis von Zink-Aluminium-Silikat eingesetzt werden.

Eine bevorzugte Ausführungsform der Erfindung sieht vor, dass die auf der Frontelektrode angeordnete elektrisch leitfähige Elektrodenschicht und/oder die auf der weiteren Elektrode angeordnete elektrisch leitfähige Elektrodenschicht transparent ausgeführt sind. Hierbei wird ein Transmissionsgrad von mind. 70% in einem Wellenlängenbereich von 400-1100 nm erreicht.

In einer weiteren bevorzugten Ausführungsform weisen die mindestens zwei porösen Trägerschichten eine unterschiedliche Porengröße auf, wobei bevorzugt die der Frontelektrode nächste poröse Trägerschicht die kleinste Porengröße aufweist und die Porengröße der porösen Trägerschichten mit zunehmender Entfernung von der Frontelektrode zunimmt. Mit abnehmender Porengröße nimmt die spezifische innere Oberfläche der Trägerschichten und damit auch die Kapillarwirkung zu.

Diese bevorzugte Ausführungsform gibt damit die bevorzugte Möglichkeit an, um sicherzustellen, dass das mindestens eine photovoltaisch aktive Material einen Konzentrationsgradienten aufweist, wenn es in die poröse Trägerschicht eingebracht ist.

Die innere Oberfläche der porösen Trägerschichten ist damit so ausgebildet, dass daraus eine differenzierte, räumlich gerichtete Ausbildung des photovoltaischen Elementes resultiert. Hierbei wird durch geschickte Ausnutzung der Eigenschaften der mindestens zwei porösen Trägerschichten, wie Porosität, Oberflächengröße, Haftstellen und Benetzung, eine räumlich selektive, selbstorganisierte, gerichtete Adsorption und Beschichtung mit dem mindestens einen photovoltaisch aktiven Material erreicht.

Eine weitere bevorzugte Ausführungsform der Erfindung sieht vor, dass die mindestens zwei porösen Trägerschichten elektrisch leitfähig oder elektrisch isolierend ausgeführt sind. Eine Beeinflussung der elektrischen Leitfähigkeit kann dabei beispielsweise dadurch erreicht werden, dass reaktive Gase und/oder Lösungen, die elektrisch leitfähige Materialien enthalten, in die mindestens zwei porösen Trägerschichten eingebracht werden.

Weiterhin ist bevorzugt, dass die Ausdehnung der mindestens zwei porösen Trägerschichten zwischen benachbarten Glaslotstegen 3 bis 10 mm beträgt und/oder die Dicke aller der mindestens zwei porösen Trägerschichten zusammen 0,5 bis 20 µm, bevorzugt 1 bis 10 µm, beträgt.

In einer weiteren bevorzugten Ausführungsform bestehen die mindestens zwei porösen Trägerschichten aus einem Material ausgewählt aus der Gruppe bestehend aus TiO₂, TiN, SiN, TiC, SiC, Al₂O₃, ZrO₂, SiO₂, Fe₂O₃, Nickeloxiden, Chromoxiden, Kobaltoxiden, Glaspigmenten, Ruß und Graphit oder aus Kombinationen hiervon.

Weiterhin ist bevorzugt, dass die elektrisch leitfähigen Elektrodenschichten aus einem Material ausgewählt aus der Gruppe bestehend aus SnO₂:F, ZnO:Al und Indiumzinnoxid oder aus Kombinationen hiervon bestehen.

Eine weitere bevorzugte Ausführungsform der Erfindung sieht vor, dass das mindestens eine photovoltaisch aktive Material ausgewählt ist aus den Gruppen bestehend aus
a) organischen und metallorganischen Farbstoffen in Kombination mit redoxfähigen Elektrolyten, bevorzugt lodiden, Kobaltkomplexen und Ferrocenen, oder in Kombination mit reversibel oxidierbaren Feststoffen, bevorzugt Triarylammoniumderivaten und spiro-OMeTAD,
b) Mischungen aus organischen Molekülen und/oder Polymeren mit Elektronen-donierenden und Elektronen-akzeptierenden Eigenschaften, bevorzugt Polythiophen-Fullerenmischungen,
c) halbleitenden anorganischen Materialien, bevorzugt CdTe, CdSe, Cu₂ZnSnS₄, FeS₂, PbS, Cu₂S, CdS, CuSCN, Bi₂S₂, Cu₃BiS₃,
d) halbleitenden Perovskiten der allgemeinen Form K-M-A₃ (K: Kation, M: Metall, A: Anion), wobei K bevorzugt ausgewählt ist aus der Gruppe bestehend aus Cs⁺, CH₃NH₃⁺, Li⁺, Imidazoliumkationen, Ammoniumkationen, Pyridiniumkationen, Bipyridyle, Ca²⁺ und Mg²⁺, M bevorzugt ausgewählt ist aus der Gruppe bestehend aus Pb, Sn, Bi, Fe, Mn, Cu, Co, W, Ti und Zn, und A bevorzugt ausgewählt ist aus der Gruppe bestehend aus I⁻, Cl⁻, F⁻, Br⁻, SCN⁻, BF₄⁻, OTT, MnO₄⁻, O²⁻, S²⁻ und SO₄²⁻,
e) sowie Kombinationen oder Teilkomponenten hiervon.

Weiterhin ist bevorzugt, dass die Frontelektrode und die weitere Elektrode zusätzlich jeweils eine Elektronen- oder Löcher-selektive Schicht enthalten. Diese dünnen Elektronen- oder Löcher-selektive Schichten bewirken dabei eine elektrisch möglichst asymmetrische (diodische) Kontaktierung des mindestens einen photovoltaisch aktiven Materials an die jeweilige Elektrodenschicht.

Die dünnen Elektronen- oder Löcher-selektiven Schichten sind dabei bevorzugt dünn ausgeführt und bestehen bevorzugt aus einem Material ausgewählt aus der Gruppe bestehend aus Titandioxid, Nickeloxid, Wolframoxid, Eisenoxid, Chromoxid, Kobaltoxid, Manganoxid, Molybdänoxid, Niobiumoxid, Kupferoxid, Antimonoxid, Zinnoxid, Zinkoxid, Bismutoxid, Bleioxid, Ceriumoxid, Ruß, Platin, Silber und Palladium.

In einer weiteren bevorzugten Ausführungsform sind innerhalb der Frontelektrode und der weiteren Elektrode sowie zwischen den Glaslotstegen und den mindestens zwei porösen Trägerschichten Kanalstrukturen zum Einfüllen von Lösungen flächig eingebracht. Hierbei handelt es sich um speziell angeordnete Kanäle sowie geeignete Fülllöcher. Durch diese können unter anderem sowohl die das photovoltaisch aktive Material enthaltende Lösung als auch Lösungen, welche chemisch modifizierende und/oder elektrisch leitfähige Materialien enthalten, in die mindestens zwei porösen Trägerschichten eingebracht werden. Dabei wird die entsprechende Lösung über die Fülllöcher in den ansonsten versiegelten Aufbau eingeleitet und über die speziell angeordneten Kanäle in die Trägerschichten eingebracht.

Durch diese bevorzugte Ausführungsform kann letztlich eine gleichmäßige Verteilung der in die mindestens zwei porösen Trägerschichten einzubringenden Lösungen erreicht werden.

Die vorliegende Erfindung betrifft auch ein Verfahren zur Herstellung eines erfindungsgemäßen photovoltaischen Elementes.

Hierbei werden auf einem mit einer elektrisch leitfähigen Elektrodenschicht beschichteten Glassubstrat mindestens zwei poröse Trägerschichten sowie mehrere Glaslotstegen aufgebracht. Anschließend findet eine Sinterung an Luft oder eventuell unter Schutzgas bzw. mit reaktiven Gasen statt, um eine unterschiedliche Porosität in den mindestens zwei Trägerschichten zu erzeugen und das organische Druckmedium in den Glaslotstegen auszubrennen. Daraufhin werden die Frontelektrode und die weitere Elektrode ohne räumlichen Abstand mit den angrenzenden porösen Trägerschichten verbunden. Anschließend wird das mindestens eine photovoltaisch aktive Material in die mindestens zwei porösen Trägerschichten eingebracht. Hierbei kann das photovoltaisch aktive Material in gelöster Form in die mindestens zwei porösen Trägerschichten eingebracht werden, wobei zunächst eine Lösung, enthaltend das mindestens eine photovoltaisch aktive Material sowie mindestens ein Lösungsmittel, in die mindestens zwei porösen Trägerschichten eingebracht wird und durch anschließende Trocknung, bevorzugt mittels durchströmendem Gas und/oder Vakuum, das mindestens eine Lösungsmittel entfernt wird.

Die Verbindung der Frontelektrode und der weiteren Elektrode mit den angrenzenden Trägerschichten kann unter Anwendung eines Fusingprozesses durchgeführt werden, wobei durch das Arbeiten oberhalb der Erweichungstemperatur der Glaslotstege sowie der Glassubstrate gewährleistet wird, dass die beiden Elektroden ohne räumlichen Abstand mit den angrenzenden porösen Trägerschichten verbunden werden.

Weiterhin ist bevorzugt, dass vor oder nach dem Einbringen der das mindestens eine photovoltaisch aktive Material enthaltenden Lösung chemisch modifizierende und/oder elektrisch leitfähige Materialien enthaltende reaktive Gase und/oder Lösungen in die mindestens zwei porösen Trägerschichten eingebracht werden. So kann beispielsweise eine Modifikation der Oberfläche und/oder eine Beeinflussung der elektrischen Leitfähigkeit der mindestens zwei porösen Trägerschichten erreicht werden.

Weiterhin ist bevorzugt, dass die mindestens zwei porösen Trägerschichten und/oder die Glaslotstege mittels Siebdruck aus einer Paste aufgebracht werden. Die mindestens zwei porösen Trägerschichten können außerdem auch durch Vorhangbeschichtung, Slot-Die-Coating oder Sprühen aufgetragen werden.

Weiterhin ist bevorzugt, dass die elektrisch leitfähigen Elektrodenschichten mittels Sprühen aus einer Lösung aufgebracht werden.

Weiterhin ist bevorzugt, dass auf den leitfähigen Elektrodenschichten der Frontelektrode und der weiteren Elektrode zusätzlich jeweils eine dünne Elektronen- oder Löcher-selektive Schicht mittels Sprühen aus einer Lösung aufgebracht wird.

Weiterhin ist bevorzugt, dass zwischen den Glaslotstegen und den mindestens zwei porösen Trägerschichten Kanalstrukturen zum Einfüllen von Lösungen per Sandstrahl, mechanisch, durch Wasserstrahl, durch Ätzen oder mittels Laser flächig eingebracht werden.

Die vorliegende Erfindung betrifft außerdem ein photovoltaisches Modul enthaltend eine interne elektrische serielle Aufschaltung von mindestens zwei erfindungsgemäßen photovoltaischen Elementen.

Die vorliegende Erfindung wird anhand der nachfolgenden Figuren sowie Beispiele näher erläutert ohne die Erfindung auf die speziell dargestellten Parameter zu beschränken.

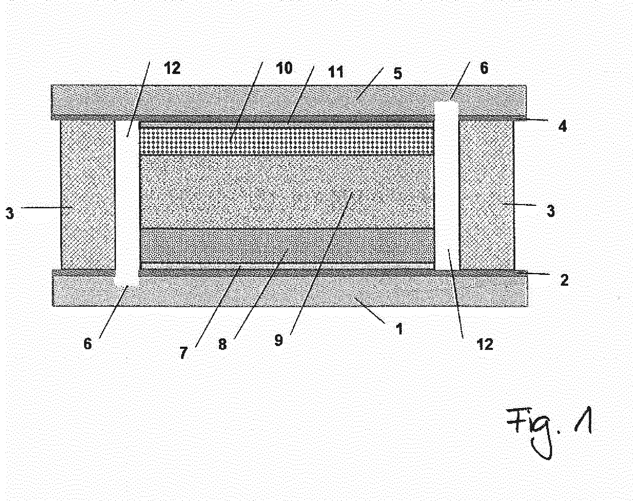

Fig. 1 zeigt den Querschnitt durch ein erfindungsgemäßes photovoltaisches Element. Es enthält eine Frontelektrode bestehend aus einem Glassubstrat (1), einer elektrisch leitfähigen Schicht (2) und einer dünnen Elektronen- oder Löcher-selektiven Schicht (7) sowie eine weitere Elektrode bestehend aus einem Glassubstrat (5), einer elektrisch leitfähigen Schicht (4) und einer dünnen Elektronen- oder Löcher-selektiven Schicht (11). Zwischen den beiden Elektroden sind drei poröse Trägerschichten (8, 9, 10) angeordnet, wobei die beiden Elektroden ohne räumlichen Abstand mit den angrenzenden porösen Trägerschichten verbunden sind. Glaslotstege (3) sind so zwischen den beiden Elektroden angeordnet, dass sie die drei porösen Trägerschichten fixieren. Die Porosität der Trägerschichten nimmt dabei von oben nach unten ab. Damit nehmen die innere Oberfläche der Trägerschichten und damit die Kapillarwirkung von oben nach unten zu. Die Kanäle (6, 12) dienen zum Einbringen von Lösungen in die porösen Trägerschichten.

Nach dem erfindungsgemäßen Verfahren werden in einem Lösungsmittel gelöste photovoltaisch aktive Materialien durch Befülllöcher eingeleitet, durch die Kanäle (6, 12) sowie die oberste Trägerschicht (10) flächig verteilt und in den darunter liegenden Trägerschichten (8, 9) durch Kapillarkräfte aufgenommen. Hierbei dient die mittlere Trägerschicht (9) als Flüssigkeitsreservoir. Anschließend wird das Lösungsmittel verdampft und durch die oberste Trägerschicht (10) und die Kanäle (6, 12) wieder abgeführt. Die Trocknung und die damit einhergehende Verringerung der Menge des Lösungsmittels finden daher von oben nach unten statt. Dies führt im Umkehrschluss zu einer Aufkonzentrierung der photovoltaisch aktiven Materialien und letztendlich zu einer Abscheidung mit hohem Füllgrad in der untersten Trägerschicht (8). Diese Trägerschicht (8) nimmt somit die photovoltaisch aktiven Materialien auf, welche einen elektrischen Kontakt mit der Frontelektrode (1, 2, 7) formen. Die elektrische Kontaktierung mit der zweiten Elektrode (4, 5, 11) wird in analoger Weise ausgeführt, wobei zur Abscheidung in den Trägerschichten (9) und (10) Lösungen aus bevorzugt leitfähig ausgerüsteten polymeren Materialien und/oder mit z.B. Rußen oder Carbon-Nanoröhren leitfähig ausgerüsteten Materialien verwendet werden.

Die relativen Dimensionen sind in Fig. 1 stark verzerrt dargestellt. Das Verhältnis Höhe zu Breite ist in Wirklichkeit H/B = 10⁻⁵-10⁻⁴.

### Beispiel:

Mit Fluor-dotiertem Zinnoxid beschichtete Floatgläser werden mit Kanalstrukturen versehen. Anschließend wird durch Sprühpyrolyse eine kompakte ca. 20 nm dicke TiO₂ Schicht (Blockinglayer) aufgebracht. Nun werden nacheinander die Trägerschichten (nanoporöses TiO₂ als unterste 0,4 µm dicke Schicht, hochporöses TiO₂ als mittlere 3 µm dicke Schicht, mikroporöses Al₂O₃ als oberste ebenfalls 2 µm dicke Schicht) und das Glaslot per Siebdruck auf die Frontelektrode gedruckt und bei 450 °C gesintert (hierbei entstehen die unterschiedlichen Porösitäten und Porengrößen in den Trägerschichten) sowie anschließend in einem Temperaturschritt (650°C) mit der Rückelektrode durch die gedruckten Glaslotstege verschmolzen. So entsteht ein kompletter Glaskörper, der die gedruckten Trägerschichten umschließt. Lediglich zwei Befüllungsöffnungen zum Einbringen der aktiven Materialien sind nun noch offen.

Nun wird Pbl₂ in einer DMF-Lösung (500mg/ml) durch eine Befüllungsöffnung und die Kanalstrukturen in die Schichten gedrückt. Durch die unterschiedlichen Porengrößen der drei Trägerschichten (Porengröße verringert sich in Richtung zur Frontelektrode) wird das Pbl₂ durch Kapillarwirkung in die unterste Schicht an der Frontelektrode transportiert. Nun wird das DMF mittels Stickstoff unter Temperatur getrocknet und das aktive Material verbleibt in der Schicht. Im nächsten Schritt wird CH₃NH₃l in einer Isopropanol-Lösung (10mg/ml) in den Zellaufbau gebracht. Das Material wird ebenfalls mittels Kapillarkräfte durch die Schichten bewegt (in einer Reaktion entsteht nun das Perowskit in der Form CH₃NH₃Pbl₃) Anschließend wird Acetonitril zum Spülen der oberen Schichten durch den Zellaufbau gedrückt und abermals mittels Stickstoff getrocknet. Als letzter Schritt wird eine Lösung von Spiro-OmeTAD (Merck) in Chlorbenzol (100mg/ml), versetzt mit elektrisch leitfähigen RußPartikeln (Degussa Printex), in den Aufbau gebracht und abermals mittels Stickstoff unter Temperatur getrocknet. Abschließend werden die Befülllöcher versiegelt und der Zellaufbau über das außerhalb der Glaslotstege liegende TCO kontaktiert.

## Patentansprüche

1. Photovoltaisches Element enthaltend
eine Frontelektrode und eine weitere Elektrode enthaltend jeweils ein Glassubstrat (1, 5) und eine auf dem Glassubstrat angeordnete elektrisch leitfähige Elektrodenschicht (2, 4),
mindestens zwei poröse Trägerschichten (8, 10), die zwischen den beiden Elektroden angeordnet sind, mehrere zwischen den beiden Elektroden zur Fixierung der mindestens zwei porösen Trägerschichten (8, 10) angeordnete Glaslotstege (3), und
mindestens ein photovoltaisch aktives Material, das in die mindestens zwei porösen Trägerschichten (8, 10) eingebracht ist und einen Konzentrationsgradienten aufweist,
**dadurch gekennzeichnet dass**
die beiden Elektroden ohne räumlichen Abstand mit den angrenzenden porösen Trägerschichten (8, 10) verbunden sind.

2. Photovoltaisches Element nach dem vorhergehenden Anspruch, **dadurch gekennzeichnet, dass** die auf der Frontelektrode angeordnete elektrisch leitfähige Elektrodenschicht (2) und/oder die auf der weiteren Elektrode angeordnete elektrisch leitfähige Elektrodenschicht (4) transparent ausgeführt ist.

3. Photovoltaisches Element nach einem der vorhergehenden Ansprüche, **dadurch gekennzeichnet, dass** die mindestens zwei porösen Trägerschichten (8, 10) eine unterschiedliche Porengröße aufweisen, wobei bevorzugt die der Frontelektrode nächste poröse Trägerschicht (8) die kleinste Porengröße aufweist und die Porengröße der porösen Trägerschichten mit zunehmender Entfernung von der Frontelektrode zunimmt.

4. Photovoltaisches Element nach einem der vorhergehenden Ansprüche, **dadurch gekennzeichnet, dass** die mindestens zwei porösen Trägerschichten (8, 10) elektrisch leitfähig oder elektrisch isolierend ausgeführt sind.

5. Photovoltaisches Element nach einem der vorhergehenden Ansprüche, **dadurch gekennzeichnet, dass** die Ausdehnung der mindestens zwei porösen Trägerschichten (8, 10) zwischen benachbarten Glaslotstegen (3) 3 bis 10 mm beträgt und/oder die Dicke aller der mindestens zwei porösen Trägerschichten (8, 10) zusammen 0,5 bis 20 µm, bevorzugt 2 bis 10 µm, beträgt.

6. Photovoltaisches Element nach einem vorhergehenden Ansprüche, **dadurch gekennzeichnet, dass** die mindestens zwei porösen Trägerschichten (8, 10) aus einem Material ausgewählt aus der Gruppe bestehend aus TiO₂, TiN, SiN, TiC, SiC, Al₂O₃, ZrO₂, SiO₂, Fe₂O₃, Nickeloxiden, Chromoxiden, Kobaltoxiden, Glaspigmenten, Ruß und Graphit oder aus Kombinationen hiervon bestehen.

7. Photovoltaisches Element nach einem der vorhergehenden Ansprüche, **dadurch gekennzeichnet, dass** die elektrisch leitfähigen Elektrodenschichten (2, 4) aus einem Material ausgewählt aus der Gruppe bestehend aus SnO₂:F, ZnO:Al und Indiumzinnoxid oder aus Kombinationen hiervon bestehen.

8. Photovoltaisches Element nach einem der vorhergehenden Ansprüche, **dadurch gekennzeichnet, dass** das mindestens eine photovoltaisch aktive Material ausgewählt ist aus den Gruppen bestehend aus
a) organischen und metallorganischen Farbstoffen in Kombination mit redoxfähigen Elektrolyten, bevorzugt lodiden, Kobaltkomplexen und Ferrocenen, oder in Kombination mit reversibel oxidierbaren Feststoffen, bevorzugt Triarylammoniumderivaten und spiro-OMeTAD,
b) Mischungen aus organischen Molekülen und/oder Polymeren mit Elektronen-donierenden und Elektronen-akzeptierenden Eigenschaften, bevorzugt Polythiophen-Fullerenmischungen,
c) halbleitenden anorganischen Materialien, bevorzugt CdTe, CdSe, Cu₂ZnSnS₄, FeS₂, PbS, Cu₂S, CdS, CuSCN, Bi₂S₂, Cu₃BiS₃,
d) halbleitenden Perovskiten der allgemeinen Form K-M-A₃ (K: Kation, M: Metall, A: Anion), wobei K bevorzugt ausgewählt ist aus der Gruppe bestehend aus Cs⁺, CH₃NH₃⁺, Li⁺, Imidazoliumkationen, Ammoniumkationen, Pyridiniumkationen, Bipyridyle, Ca²⁺ und Mg²⁺, M bevorzugt ausgewählt ist aus der Gruppe bestehend aus Pb, Sn, Bi, Fe, Mn, Cu, Co, W, Ti und Zn, und A bevorzugt ausgewählt ist aus der Gruppe bestehend aus I⁻, Cl⁻, F⁻, Br⁻, SCN⁻, BF₄⁻, OTf⁻, MnO₄⁻, O²⁻, S²⁻ und SO₄²⁻,
e) sowie Kombinationen oder Teilkomponenten hiervon.

9. Photovoltaisches Element nach einem der vorhergehenden Ansprüche, **dadurch gekennzeichnet, dass** die Frontelektrode und die weitere Elektrode zusätzlich jeweils eine Elektronen- oder Löcher-selektive Schicht (7, 11) enthalten, wobei die Elektronen- oder Löcher-selektiven Schichten bevorzugt aus einem Material ausgewählt aus der Gruppe bestehend aus Titandioxid, Nickeloxid, Wolframoxid, Eisenoxid, Chromoxid, Kobaltoxid, Manganoxid, Molybdänoxid, Niobiumoxid, Kupferoxid, Antimonoxid, Zinnoxid, Zinkoxid, Bismutoxid, Bleioxid, Ceriumoxid, Ruß, Platin, Silber und Palladium bestehen.

10. Photovoltaisches Element nach einem der vorhergehenden Ansprüche, **dadurch gekennzeichnet, dass** innerhalb der Frontelektrode und der weiteren Elektrode sowie zwischen den Glaslotstegen (3) und den mindestens zwei porösen Trägerschichten (8, 10) Kanalstrukturen (6, 12) zum Einfüllen von Lösungen eingebracht sind.

11. Verfahren zur Herstellung eines photovoltaischen Elementes gemäß mindestens einem der vorhergehenden Ansprüche, **dadurch gekennzeichnet, dass** die Frontelektrode und die weitere Elektrode ohne räumlichen Abstand mit den angrenzenden porösen Trägerschichten (8, 10) verbunden werden und anschließend das mindestens eine photovoltaisch aktive Material sowie mindestens ein Lösungsmittel, sukzessive in die mindestens zwei porösen Trägerschichten (8, 10) eingebracht und durch anschließende Trocknung das mindestens eine Lösungsmittel entfernt wird.

12. Verfahren nach dem vorhergehenden Anspruch, **dadurch gekennzeichnet, dass** vor oder nach dem Einbringen der das mindestens eine photovoltaisch aktive Material enthaltenden Lösung chemisch modifizierende und/oder elektrisch leitfähige Materialien enthaltende reaktive Gase und/oder Lösungen in die mindestens zwei porösen Trägerschichten (8, 10) eingebracht werden.

13. Verfahren nach einem der Ansprüche 11-12, **dadurch gekennzeichnet, dass** die mindestens zwei porösen Trägerschichten (8, 10) und/oder die Glaslotstege (3) mittels Siebdruck aus einer Paste aufgebracht werden.

14. Verfahren nach einem der Ansprüche 11-13, **dadurch gekennzeichnet, dass** die elektrisch leitfähigen Elektrodenschichten (2, 4) mittels Sprühen aus einer Lösung aufgebracht werden und/oder auf die leitfähigen Elektrodenschichten der Frontelektrode und der weiteren Elektrode zusätzlich jeweils eine Elektronen- oder Löcher-selektive Schicht (7, 11) mittels Sprühen aus einer Lösung aufgebracht wird.

15. Verfahren nach einem der Ansprüche 11-14, **dadurch gekennzeichnet, dass** zwischen den Glaslotstegen (3) und den mindestens zwei porösen Trägerschichten (8, 10) Kanalstrukturen (6, 12) zum Einfüllen von Lösungen per Sandstrahl, mechanisch, durch Wasserstrahl, durch Ätzen oder mittels Laser flächig eingebracht werden.

16. Photovoltaisches Modul enthaltend eine interne elektrische serielle Aufschaltung von mindestens zwei photovoltaischen Elementen nach einem der Ansprüche 1-10.

## Claims

1. Photovoltaic element comprising
one front electrode and one further electrode comprising respectively one glass substrate (1, 5) and one electrically conductive electrode layer (2, 4) which is disposed on the glass substrate,
at least two porous carrier layers (8, 10) which are disposed between the two electrodes,
a plurality of glass solder webs (3) disposed between the two electrodes for fixing the at least two porous carrier layers (8, 10), and
at least one photovoltaically active material which is introduced into the at least two porous carrier layers (8, 10) and has a concentration gradient,
**characterized in that**
the two electrodes are connected to the adjacent porous carrier layers (8, 10) without a spatial interval.

2. Photovoltaic element according to the preceding claim, **characterised in that** the electrically conductive electrode layer (2) disposed on the front electrode and/or the electrically conductive electrode layer (4) disposed on the further electrode has a transparent design.

3. Photovoltaic element according to one of the preceding claims, **characterised in that** the at least two porous carrier layers (8, 10) have a different pore size, preferably the porous carrier layer (8) next to the front electrode having the smallest pore size and the pore size of the porous carrier layers increasing at increasing distance from the front electrode.

4. Photovoltaic element according to one of the preceding claims, **characterised in that** the at least two porous carrier layers (8, 10) are designed to be electrically conductive or electrically insulating.

5. Photovoltaic element according to one of the preceding claims, **characterised in that** the extension of the at least two porous carrier layers (8, 10) between adjacent glass solder webs (3) is 3 to 10 mm and/or the thickness of all of the at least two porous carrier layers (8, 10) in total is 0.5 to 20 µm, preferably 2 to 10 µm.

6. Photovoltaic element according to one of the preceding claims, **characterised in** the at least two porous carrier layers (8, 10) consist of a material selected from the group consisting of TiO₂, TiN, SiN, TiC, SiC, Al₂O₃, ZrO₂, SiO₂, Fe₂O₃, nickel oxides, chromium oxides, cobalt oxides, glass pigments, carbon black and graphite or combinations hereof.

7. Photovoltaic element according to one of the preceding claims, **characterised in that** the electrically conductive electrode layers (2, 4) consist of a material selected from the group consisting of SnO₂:F, ZnO:Al and indium tin oxide or combinations hereof.

8. Photovoltaic element according to one of the preceding claims, **characterised in that** the at least one photovoltaically active material is selected from the groups consisting of
a) organic and organometallic dyes in combination with redoxable electrolytes, preferably iodides, cobalt complexes and ferrocenes or in combination with reversibly oxidisable solids, preferably triarylammonium derivatives and spiro-OMeTAD,
b) mixtures of organic molecules and/or polymers with electron-donating and electron-accepting properties, preferably polythiophene-fullerene mixtures,
c) semiconducting inorganic materials, preferably CdTe, CdSe, Cu₂ZnSnS₄, FeS₂, PbS, Cu₂S, CdS, CuSCN, Bi₂S₂, Cu₃BiS₃,
d) semiconducting perovskites of the general form K-M-A₃ (K: cation, M: metal, A: anion), K being selected preferably from the group consisting of Cs⁺, CH₃NH₃⁺, Li⁺, imidazolium cations, ammonium cations, pyridinium cations, bipyridyls, Ca²⁺ and Mg²⁺, M being selected preferably from the group consisting of Pb, Sn, Bi, Fe, Mn, Cu, Co, W, Ti and Zn and A being selected preferably from the group consisting of I⁻, Cl⁻, F⁻, Br⁻, SCN⁻, BF₄⁻, OTf⁻, MnO₄⁻, O²⁻, S²⁻ and SO₄²⁻,
e) and also combinations or partial components hereof.

9. Photovoltaic element according to one of the preceding claims, **characterised in that** the front electrode and the further electrode comprise in addition respectively one electron- or hole-selective layer (7, 11), the electron- or hole-selective layers consisting preferably of a material selected from the group consisting of titanium dioxide, nickel oxide, tungsten oxide, iron oxide, chromium oxide, cobalt oxide, manganese oxide, molybdenum oxide, niobium oxide, copper oxide, antimony oxide, tin oxide, zinc oxide, bismuth oxide, lead oxide, cerium oxide, carbon black, platinum, silver and palladium.

10. Photovoltaic element according to one of the preceding claims, **characterised in that** channel structures (6, 12) for pouring in solutions are introduced inside the front electrode and the further electrode and also between the glass solder webs (3) and the at least two porous carrier layers (8, 10).

11. Method for the production of a photovoltaic element according to at least one of the preceding claims, **characterised in that** the front electrode and the further electrode are connected to the adjacent porous carrier layers (8, 10) without a spatial interval and subsequently the at least one photovoltaically active material and also at least one solvent are introduced, in succession, into the at least two porous carrier layers (8, 10) and the at least one solvent is removed by subsequent drying.

12. Method according to the preceding claim, **characterised in that**, before or after introduction of the solution comprising the at least one photovoltaically active material, reactive gases and/or solutions comprising chemically modifying and/or electrically conductive materials are introduced into the at least two porous carrier layers (8, 10).

13. Method according to one of the claims 11 - 12, **characterised in that** the at least two porous carrier layers (8, 10) and/or the glass solder webs (3) are applied by means of screen printing from a paste.

14. Method according to one of the claims 11 - 13, **characterised in that** the electrically conductive electrode layers (2, 4) are applied by means of spraying from a solution and/or in addition respectively one electron- or hole-selective layer (7, 11) is applied on the conductive electrode layers of the front electrode and of the further electrode by means of spraying from a solution.

15. Method according to one of the claims 11 - 14, **characterised in that** channel structures (6, 12) for pouring in solutions are introduced in a planar manner between the glass solder webs (3) and the at least two porous carrier layers (8, 10) by sand blasting, mechanically, by water jet, by etching or by means of laser.

16. Photovoltaic module comprising an internal electrical series connection of at least two photovoltaic elements according to one of the claims 1 - 10.

## Revendications

1. Élément photovoltaïque contenant
une électrode frontale et une autre électrode contenant chacune un substrat de verre (1, 5) et une couche d'électrode électro-conductrice (2, 4) disposée sur le substrat de verre,
au moins deux couches de support poreuses (8, 10) qui sont disposées entre les deux électrodes,
plusieurs nervures de brasure de verre (3) disposées entre les deux électrodes pour la fixation des au moins deux couches de support poreuses (8, 10) et
au moins un matériau photovoltaïquement actif, qui est inséré dans les au moins deux couches de support poreuses (8, 10) et qui présente un gradient de concentration,
**caractérisé en ce que** les deux électrodes sont reliées sans distance spatiale avec les couches de support poreuses (8, 10) adjacentes.

2. Élément photovoltaïque selon la revendication précédente, **caractérisé en ce que** la couche d'électrode électro-conductrice (2) disposé sur l'électrode frontale et/ou la couche d'électrode électro-conductrice (4) disposée sur l'autre électrode sont réalisées de manière transparente.

3. Élément photovoltaïque selon l'une des revendications précédentes, **caractérisé en ce que** les au moins deux couches de support poreuses (8, 10) présentent des tailles de pores différentes, de préférence la couche de support poreuse (8) la plus proche de l'électrode frontale présentant la taille de pores la plus petite et la taille de pores des couches de support poreuses augmentant lorsque la distance par rapport à l'électrode frontale augmente.

4. Élément photovoltaïque selon l'une des revendications précédentes, **caractérisé en ce que** les au moins deux couches de support poreuses (8, 10) sont réalisées de manière électro-conductrice ou de manière électriquement isolante.

5. Élément photovoltaïque selon l'une des revendications précédentes, **caractérisé en ce que** l'extension des au moins deux couches de support poreuses (8, 10) est, entre des nervures à brasure de verre (3), de 3 à 10 mm et/ou l'épaisseur de toutes les au moins deux couches de support poreuses (8, 10) ensemble est de 0,5 à 20 µm, de préférence de 2 à 10 µm.

6. Élément photovoltaïque selon l'une des revendications précédentes, **caractérisé en ce que** les au moins deux couches de support poreuses (8, 10) sont constituées d'un matériau sélectionné dans le groupe constitué de TiO₂, TiN, SiN, TiC, SiC, Al₂O₃, ZrO₂, SiO₂, Fe₂O₃, oxydes de nickel, oxydes de chrome, oxydes de cobalt, pigments de verre, suie et graphite ou de combinaisons de ceux-ci.

7. Élément photovoltaïque selon l'une des revendications précédentes, **caractérisé en ce que** les couches d'électrodes électro-conductrices (2, 4) sont constituées d'un matériau sélectionné dans le groupe constitué de SnO₂:F ; ZnO:Al et de l'oxyde d'indium et d'étain ou de combinaisons de ceux-ci.

8. Élément photovoltaïque selon l'une des revendications précédentes, **caractérisé en ce que** l'au moins un matériau photovoltaïquement actif est sélectionné dans les groupes constitués de
a) pigments organiques et organométalliques en combinaison avec des électrolytes redox, de préférence des iodures, des complexes de cobalt et des ferrocènes ou en combinaison avec des matières solides oxydables de manière réversibles, de préférence des dérivés de triarylammonium et du spiro-OmeTAD
b) mélanges de molécules organiques et/ou de polymères avec des propriétés de don d'électrons et d'acceptation d'électrons, de préférence des mélanges polythiophènes-fullerènes,
c) des matériaux semi-conducteurs inorganiques, de préférence CdTe, CdSe, Cu₂ZnSnS₄, FeS₂, PbS, Cu₂S, CdS, CuSCN, Bi₂S₂, Cu₃BiS₃,
d) des pérovskites semi-conductrices de forme générale K-M-A₃ (K : cation, M : métal, A: anion), K étant de préférence sélectionné dans le groupe constitué de Cs⁺, CH₃NH₃⁺, Li⁺, de cations d'imidazolium, de cations d'ammonium, de cations de pyridinium, de bipyridyle, Ca²⁺ et Mg²⁺, M étant de préférence sélectionné dans le groupe constitué de Pb, Sn, Bi, Fe, Mn, Cu, Co, W, Ti et Zn et A étént de préférence sélectionné dans le groupe constitué de I⁻, Cl⁻, F⁻, Br⁻, SCN⁻, BF₄⁻, Otf, MnO₄⁻, O²⁻, S²⁻ et SO₄²⁻,
e) ainsi que des combinaisons et des composants partiels de ceux-ci.

9. Élément photovoltaïque selon l'une des revendications précédentes, **caractérisé en ce que** l'électrode frontale et l'autre électrode contiennent chacune en outre une couche sélective à électrons ou à trous (7, 11), les couches sélectives à électrons ou à trous étant de préférence constituées d'un matériau sélectionné dans le groupe constitué d'oxyde de titane, d'oxyde de nickel, d'oxyde de tungstène, d'oxyde de fer, d'oxyde de chrome, d'oxyde de cobalt, d'oxyde de manganèse, d'oxyde de molybdène, d'oxyde de niobium, d'oxyde de cuivre, d'oxyde d'antimoine, d'oxyde d'étain, d'oxyde de zinc, d'oxyde de bismuth, d'oxyde de plomb, d'oxyde de cérium, de suie, de platine, d'argent et de palladium.

10. Élément photovoltaïque selon l'une des revendications précédentes, **caractérisé en ce que**, à l'intérieur de l'électrode frontale et de l'autre électrode ainsi qu'entre les nervures à brasure de verre (3) et les au moins deux couches de support poreuses (8, 10), sont insérées des structures de canaux (6, 12) pour l'introduction de solutions.

11. Procédé de fabrication d'un élément photovoltaïque selon au moins une des revendications précédentes, **caractérisé en ce que** l'électrode frontale et l'autre électrode sont reliées sans distance spatiale avec les couches de support poreuses (8, 10) puis l'au moins un matériau photovoltaïquement actif ainsi qu'au moins un solvant sont introduits successivement dans les au moins deux couches de support poreuses (8, 10) et l'au moins un solvant est ensuite éliminé par séchage.

12. Procédé selon la revendication précédente, **caractérisé en ce que**, avant ou après l'introduction de la solution contenant au moins un matériau photovoltaïquement actif, des gaz et/ou des solutions réactives contenant des matériaux modificateurs chimiques et/ou électro-conducteurs sont introduits dans les au moins deux couches de support poreuses (8, 10).

13. Procédé selon l'une des revendications 11 à 12, **caractérisé en ce que** les au moins deux couches de support poreuses (8, 10) et/ou les nervures à brasure de verre (3) sont appliquées par sérigraphie sur une pâte.

14. Procédé selon l'une des revendications 11 à 13, **caractérisé en ce que** les couches d'électrodes électro-conductrices (2, 4) sont appliquées par pulvérisation à partir d'une solution et/ou, sur les couches d'électrodes conductrices de l'électrode frontale et de l'autre électrode, est appliquée respectivement une couche sélective d'électrons ou de trous (7, 11) par pulvérisation à partir d'une solution.

15. Procédé selon l'une des revendications 11 à 14, **caractérisé en ce que**, entre les nervures de brasure de verre (3) et les au moins deux couches de support poreuses (8, 10) sont réalisées, sur toute la surface, des structures de canaux (6, 12) pour l'introduction de solutions par sablage, mécaniquement, par jet d'eau, par gravure ou à l'aide d'un laser.

16. Module photovoltaïque contenant une connexion électrique interne en série d'au moins deux éléments photovoltaïques selon l'une des revendications 1 à 10.
